# EUROPÄISCHE PATENTSCHRIFT

(11) **EP 0 833 389 B1**
(45) Veröffentlichungstag und Bekanntmachung des Hinweises auf die Patenterteilung: **05.03.2008**
(21) Anmeldenummer: 97116395.1
(22) Anmeldetag: 19.09.1997
(51) Int. Cl.: H01L 29/744, H01L 29/417

(54) **GTO-Thyristor**
GTO thyristor
Thyristor de type GTO

(30) Priorität: 30.09.1996 DE 19640444
(43) Veröffentlichungstag der Anmeldung: 01.04.1998
(73) Patentinhaber: Infineon Technologies AG, 81669 München (DE)
(72) Erfinder: Franz, Günther, Dr.rer.nat., 81929 München (DE)
(74) Vertreter: Patentanwälte Westphal, Mussgnug & Partner

(56) Entgegenhaltungen:
- EP-A- 0 235 706
- EP-A- 0 391 337
- US-A- 5 010 384
- PATENT ABSTRACTS OF JAPAN vol. 11, no. 117 (E-498) [2564], 11. April 1987 (1987-04-11) & JP 61 263163 A (MITSUBISHI ELECTRIC CORP), 21. November 1986 (1986-11-21)

## Beschreibung

Die Erfindung betrifft einen GTO-Thyristor, mit einer Kathoden- und Gateanordnung und einer Feldplatten-Abschirmung an der Halbleiteroberfläche.

Bei einem GTO-Thyristor (GTO = Gate Turn-Off) sind bekanntlich mehrere Einzelthyristoren auf einer Tablette parallel zueinander geschaltet. Die Tablette enthält dabei den Halbleiterkörper sowie die einzelnen Elektroden der Einzelthyristoren. Die Emitterelektroden der Einzelthyristoren werden durch eine vorzugsweise aus Molybdän bestehende Druckplatte kontaktiert, welche auf die Tablette aufgepreßt wird.

Bei einem derartigen GTO-Thyristor müssen für eine einwandfreies Betriebsverhalten die folgenden Voraussetzungen erfüllt werden:
(a) Bei jedem Einzelthyristor müssen offenliegende pn-Übergänge beispielsweise zwischen der Emitterzone und der Basiszone gegen Einflüsse elektrischer und chemischer Art passiviert werden.
(b) Für einen stabilen Dauerbetrieb sollte im Sperrfall des GTO-Thyristors ein Oberflächendurchbruch bei höheren Spannungen als ein Durchbruch im Innern des GTO-Thyristors erfolgen.
(c) Es muß verhindert werden, daß im Abschaltfall des GTO-Thyristors einige wenige Einzelthyristoren am Ende des Abschaltvorganges den gesamten Laststrom übernehmen müssen, da sonst diese Einzelthyristoren zerstört werden würden.

Um diesen verschiedenen Forderungen zu genügen, werden bisher die folgenden Maßnahmen ergriffen:
Zum Schutz der offenliegenden pn-Übergänge wird eine Passivierung durch Isolationsschichten aus beispielsweise Siliziumdioxid, Siliziumnitrid oder Polyimid vorgenommen. Durch diese Passivierung wird aber keine induktive Abschirmung gegen externe Ladungen erreicht.

Weiterhin wird an der Oberfläche des Halbleiterkörpers eine Abreicherung bzw. Verringerung der Dotierungskonzentration vorgenommen. Dadurch kann im Sperrfall eine Steigerung der Oberflächendurchbruchsspannung erreicht werden, so daß ein Durchbruch nicht an der Oberfläche, sondern im Innern des GTO-Thyristors auftritt.

Schließlich wird durch geeignete technologische Maßnahmen bei der Herstellung des GTO-Thyristors angestrebt, alle Einzelthyristoren so ähnlich wie möglich herzustellen, da davon ausgegangen wird, daß ein aus gleichen Einzelthyristoren aufgebauter GTO-Thyristor bzw. die diesen GTO-Thyristor bildende "homogene Thyristormatrix" gleichzeitig abschaltet.

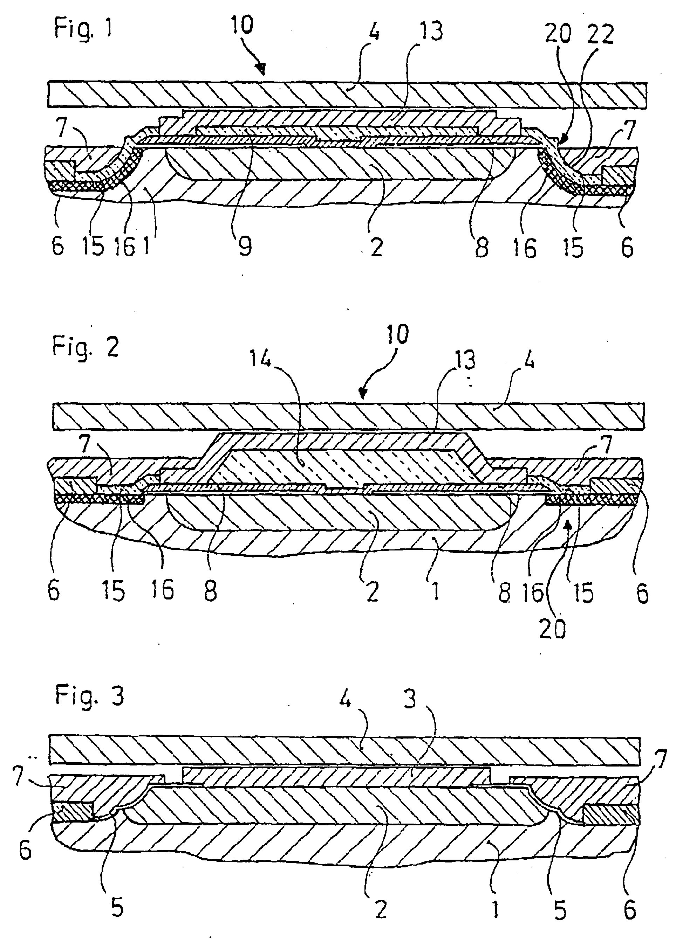

In Figur 3 ist eine herkömmliche Kathodenanordnung gezeigt, die ähnlich zu einer Kathodenanordnung bei einem beispielsweise aus der US-A 5,010,384 bekannten GTO-Thyristor ist.

Wie in Figur 3 gezeigt ist, ist auf einer Basiszone 1 der Kathodenanordnung in einer Mesastruktur eine Emitterzone 2 angeordnet, auf der sich eine Emitterelektrode 3 aus beispielsweise Aluminium befindet. Die Emitterelektrode 3 wird durch eine vorzugsweise aus Molybdän bestehende Druckplatte 4 kontaktiert, wobei diese Druckplatte 4 gemeinsam für eine Vielzahl von solchen Einzelthyristoren vorgesehen ist, welche insgesamt den GTO-Thyristor bilden.

Der an die Oberfläche des Halbleiterkörpers aus der Basiszone 1 und der Emitterzone 2 (die übrigen beiden Zonen des Thyristors sind hier nicht gezeigt) tretende pn-Übergang zwischen der Basiszone 1 und der Emitterzone 2 ist durch eine Passivierungsschicht 5 geschützt, die aus einer Siliziumdioxidschicht und/oder einer Siliziumnitridschicht besteht.

Die Basiszone 1 ist durch Elektroden 6 kontaktiert, die sich infolge der Mesastruktur in einem ausreichenden Abstand von der Druckplatte 4 befinden. Um einen Durchschlag zwischen den Gate-Elektroden 6 und der Druckplatte 4 zu verhindern, ist zusätzlich noch eine Isolationsschicht 7 (Gate-Isolation) aus Polyimid vorgesehen.

Ein weiterer gattungsbildender Thyristor in einer Planar-Anordnung ist aus EP 0 235 706 A2 bekannt. Dabei sind zur Erhöhung der Durchbruchspannung rahmenartige Feldplattenstreifen vorgesehen, welche an der Halbleiteroberfläche den Haupt-pn-Übergang und den pn-Übergang zwischen Basiszone und Emitterzone der Gateanordnung überdecken. Zwischen den pn-Übergängen ist die Halbleiteroberfläche ohne Feldplattenabschirmung. Da in den Krümmungsbereichen der Wannen hohe Feldstärken vorhanden sind, besteht die Gefahr, dass dort leicht Spannungsdurchbrüche auftreten. Ein weiterer GTO-Thyristor ist aus der JP 61-263163 bekannt.

Der Erfindung liegt die Aufgabe zugrunde, einen Thyristor der eingangs genannten Art anzugeben, bei welchem Spannungsdurchbrüche verhindert werden.

Diese Aufgabe wird dadurch gelöst, dass die Feldplattenabschirmung an der Halbleiteroberfläche als lückenlose Abdeckung zumindest desjenigen Bereiches der Basiszone der Kathodenanordnung ausgebildet ist, in welchem sich die Raumladungszone ausbildet, und dass die Ausdehnung der Raumladungszone durch eine Stopper-Zone vom Typ der Basiszone begrenzt ist, die eine gegenüber der Basiszone erhöhte Dotierung aufweist, und bis wenigstens unter einen Rand der Feldplattenabschirmung reicht. Bevorzugt ist neben der Feldplattenabschirmung ein seitlich mündender, von der Feldplattenabschirmung freier Durchtrittsbereich für die Feldstärke-Äquipotentiallinien vorhanden.

Weitere bevorzugte Ausgestaltungen der Erfindung sind in den Unteransprüchen beschrieben.

Bei der erfindungsgemässen Kathodenanordnung wird also die Feldplattenabschirmschicht über denjenigen Bereichen vorgesehen, in welchen sich die für den Schaltbereich relevanten Raumladungszonen befinden, um so eine elektrische Abschirmung gegen externe Ladungen zu bewirken und das Oberflächenpotential einzustellen. Trotzdem ist sichergestellt, dass die Feldstarke-Äquipotentiallinien nicht unterbrochen werden. Die räumliche Begrenzung des Ausbreitungsbereiches der Raumladungszonen wird durch die Stopper-Zonen festgelegt. Es erfolgt also eine gezielte räumliche Gestaltung der Raumladungszone, die gewährleistet, daß sich die Raumladungszone ausschließlich unterhalb der Feldplattenabschirmung ausdehnt bzw. durch diese vollständig abgedeckt ist.

Die Abschirmschicht bzw. Feldplatte überdeckt dabei bevorzugt auch den an die Oberfläche des Halbleiterkörpers des GTO-Thyristors tretenden pn-Übergang zwischen der Basiszone und der Emitterzone der Kathodenanordnung. Dadurch wird dieser besonders kritische Bereich ebenfalls gegen externe induktive Ladungseinflüsse abgeschirmt.

Die Abschirmschicht kann auch in besonders vorteilhafter Weise als Vorwiderstand verwendet werden:
Hierzu wird die Abschirmschicht von der Mitte der Emitterzone auf einer Isolatorschicht in einen Bereich oberhalb des an die Oberfläche des Halbleiterkörpers tretenden pn-Überganges zwischen Basiszone und Emitterzone geführt und dort von der Emitterelektrode kontaktiert, so daß die Abschirmschicht einen "lateralen" Widerstand bildet. In der bereits erwähnten US-A 5, 010,384 ist zwar ebenfalls eine Widerstandsschicht bei einem GTO-Thyristor auf dessen Emitterelektrode vorgesehen. Dort ist aber die Widerstandsschicht in Stapelrichtung direkt zwischen Emitterzone und Emitterelektrode vorgesehen, so daß kein laterale Anordnung vorliegt.

Für die Abschirmschicht kann in bevorzugter Weise dotiertes polykristallines Silizium verwendet werden, wodurch gegebenenfalls der Widerstandswert dieser Abschirmschicht in geeigneter Weise eingestellt werden kann.

Die erfindungsgemäße Kathodenanordnung ist nicht nur auf GTO-Thyristoren in Mesastruktur, sondern auch auf GTO-Thyristoren in Planarstruktur anwendbar. Für diesen zuletzt genannten Fall, bei dem die Emitterzone und die Basiszone planar gestaltet sind, kann beispielsweise die Emitterelektrode durch eine teilweise unterhalb von dieser vorgesehene Isolatorschicht in ihrer Schichtdicke verstärkt werden, so daß ein ausreichender Abstand zwischen der Unterseite der die Oberfläche der Emitterelektrode kontaktierenden Druckplatte und der Oberseite der Gate-Elektroden gewährleistet ist. Ist dieser Abstand nämlich zu gering, so erfolgt gegebenenfalls ein Durchbruch zwischen der mehrere 1000 Einzelthyristoren bzw. deren Emitterelektroden kontaktierenden Druckplatte und einzelnen Gate-Elektroden von Einzelthyristoren.

Nachfolgend wird die Erfindung anhand der Zeichnungen näher erläutert.

Es zeigen:
Figur 1 einen Schnitt durch eine Kathodenanordnung gemäß einem ersten Ausführungsbeispiel der vorliegenden Erfindung,
Figur 2 einen Schnitt durch eine Kathodenanordnung gemäß einem zweiten Ausführungsbeispiel der vorliegenden Erfindung und
Figur 3 einen Schnitt durch eine bereits bestehende Kathodenanordnung.
Figur 3 ist bereits eingangs erläutert worden.

In den Figuren 1 und 2 werden einander entsprechende Bauteile mit den gleichen Bezugszeichen wie in Figur 3 versehen.

Figur 1 zeigt eine Kathodenordnung in Mesastruktur, während in Figur 2 eine Kathodenanordnung in Planarstruktur dargestellt ist.

Im Ausführungsbeispiel von Figur 1 ist zunächst - ähnlich wie bei der bestehenden Kathodenanordnung gemäß Figur 3 - die Flanke 21 der Mesastruktur durch eine Isolatorschicht 15 geschützt, die als Passivierungsschicht wirkt und sich von der Gate-Elektrode 6 bis an die Halbleiteroberfläche in den Bereich der Mitte der Oberfläche der Emitterzone 2 erstreckt. Für diese Isolatorschicht 15 kann beispielsweise Siliziumdioxid verwendet werden. Die an der Halbleiteroberfläche verlaufende Isolationsschicht_7, die beispielsweise aus Polyimid oder Schutzlacken oder Siliziumnitrid besteht, verhindert wie bei der Kathodenanordnung von Figur 3 einen Kurzschluß zu der vorzugsweise aus Molybdän bestehenden Druckplatte 4.

Im Unterschied zu der Kathodenanordnung nach Figur 3 ist bei der erfindungsgemäßen Kathodenanordnung (10) Feldplattenabschirmung (8) eine Abschirmschicht 8 aus beispielsweise dotiertem polykristallinem Silizium ununterbrochen zwischen dem Mittenbereich der Oberfläche der Emitterzone 2 über dem Bereich oberhalb des pn-Überganges zwischen der Basiszone 1 und der Emitterzone 2 geführt. Diese Abschirmschicht 8 wird im Bereich oberhalb des pn-Überganges durch eine Emitterelektrode 13 kontaktiert, die ihrerseits unter Druckbeaufschlagung von der Molybdän-Druckplatte 4 steht. Im Mittenbereich der Abschirmschicht 8 ist oberhalb von dieser noch eine Isolationsschicht 9 aus beispielsweise Siliziumdioxid vorgesehen, so daß die Abschirmschicht 8 bei entsprechender Dotierung zugleich als Widerstand wirkt, der von der Mitte der Emitterzone 2 in den Bereich des pn-Überganges "lateral" geführt ist.

Die Isolatorschicht 15 bildet zwischen der Isolationsschicht 7 und der Basiszone 1 der Kathodenanordnung 10 einen an der Halbleiteroberfläche mündenden Isolatorspalt 22, der neben der Abschirmschicht 8 angeordnet ist. Auf diese Weise ist die Basiszone 1 einerseits in Lotrichtung zur Halbleiteroberfläche gesehen lückenlos abgedeckt, andererseits ist unterhalb der Abschirmschicht 8 ein seitlich in den Isolatorspalt 22 mündender Austrittsbereich 20 für die Feldstärke-Äquipotentiallinien (nicht dargestellt) vorhanden, so daß diese durch die Abschirmschicht 8 und die Isolationsschicht 7 nicht unterbrochen werden.

Der von der Abschirmschicht 8 abgeschirmte Bereich der Basiszone 1, in welchem sich die Raumladungszone ausbildet, wird in Richtung auf die Gate-Elektrode von einer Stopper-Zone 16 vom Typ der Basiszone 1 begrenzt. Sie weist gegenüber der Dotierung der Basiszone 1 eine erhöhte Dotierung auf, die so gewählt ist, daß sie ein weiteres Ausbreiten der Raumladungszone in diesen Bereich hinein und aus dem abgeschirmten Bereich heraus verhindert. Das heißt anders ausgedrückt, daß die Stopper-Zone 16 mit erhöhter Dotierung so weit ausgedehnt ist, daß sie mindestens bis unter den Rand der Abschirmschicht 8 reicht um sicherzustellen, daß sich kein Teil der Raumladungszone außerhalb der Feldplattenabschirmung erstrecken kann. Sie hat somit die Funktion einer räumlichen Gestaltung und Begrenzung des Ausbreitungsbereiches für die Raumladungszone. Die Abschirmschicht 8 kann die Stopper-Zone 16 auch überlappen, wenn dies zur Verbesserung der Abschirmwirkung zweckmäßig ist.
Die Stopperzone ist in dem dargestellten Beispiel als relativ dünne Schicht ausgebildet, die an den Isolatorspalt 22 und die Gate-Elektrode 6 anschließt.

Das Ausführungsbeispiel von Figur 2 zeigt eine Planarstruktur, d.h. die Oberfläche der Emitterzone 2 und der Basiszone 1 liegen hier in einer Ebene. Um dennoch einen ausreichenden Abstand zwischen der Unterseite der Druckplatte 4 und der Oberseite der Gate-Elektroden 6 zu gewährleisten, ist hier die Emitterelektrode 13 durch eine Isolatorschicht 14 aus beispielsweise Siliziumdioxid "verstärkt". Dadurch kann der erwähnte Abstand bzw. die Höhe des "Höckers" aus der Emitterelektrode 13 und der Isolatorschicht 14 auf einen Wert zwischen 10 und 20 µm eingestellt werden. Ein derartiger Abstand ist ausreichend, um zuverlässig einen Kurzschluß zwischen Druckplatte 4 und Gate-Elektrode 6 zu vermeiden.

Bei dem Ausführungsbeispiel gemäß Fig. 2 ist die Stopper-Zone 16 wie beim Beispiel gemäß Fig. 1 unter sinngemäßer Anpassung an die Gegebenheiten der planaren Ausführung ausgebildet. Die planare Anordung schafft im übrigen einen seitlichen Durchtrittsbereich 20 für die Feldstärke-Äquipotentiallinien unterhalb der Stopper-Zone 16.

Die Erfindung zeichnet sich zusammenfassend dadurch aus, daß zusätzlich mindestens eine leitfähige Schicht in Form der Abschirmschicht 8, die vorzugsweise aus polykristallinem Silizium besteht, aufgebracht wird, welche als "Feldplatte" den Einfluß von externen Ladungen abschirmt. Gleichzeitig wird durch diese Schicht 8 das Oberflächenpotential eingestellt. Auch kann die Abschirmschicht 8 als Vorschaltwiderstand für die Einzelthyristoren zwischen deren Emitterzone und Emitterelektrode wirken.

## Patentansprüche

1. GTO-Thyristor mit einer Kathoden- und Gateanordnung und einer Feldplattenabschirmung (8) an der Halbleiteroberfläche,
**dadurch gekennzeichnet,**
**daß** die Feldplattenabschirmung an der Halbleiteroberfläche als lückenlose Abdeckung zumindest des jenigen Bereichs der Basiszone (1) der Kathodenanordnung (10) ausgebildet ist, in welchem sich die Raumladungszone ausbildet, daß die Ausdehnung der Raumladungszone durch eine Stopper-Zone (16) vom Typ der Basiszone (1) begrenzt ist, die eine gegenüber der Basiszone (1) erhöhte Dotierung aufweist und bis wenigstens unter einen Rand der Feldplattenabschirmung reicht.

2. GTO-Thyristor nach Anspruch 1,
**dadurch gekennzeichnet,**
**daß** neben der Feldplattenabschirmung ein seitlich mündender, von der Feldplattenabschirmung freier Durchtrittsbereich (20) für die Feldstärke-Äquipotentiallinien vorhanden ist.

3. GTO-Thyristor nach Anspruch 1 oder 2,
**dadurch gekennzeichnet,**
**daß** bei einer Mesastruktur der Basiszone (1) der Kathodenanordnung zwischen der Flanke (21) der Mesastruktur (1) und einer benachbarten, an der Halbleiteroberfläche verlaufende Isolationsschicht (7) unter Bildung eines Isolatorspaltes (22) eine Isolatorschicht (15) vorhanden ist, und daß der Isolatorspalt (22) den Austrittsbereich (20) für die Feldstärke-Äquipotentiallinien bildet.

4. GTO-Thyristor nach einem der vorhergehenden Ansprüche,
**dadurch gekennzeichnet,**
**daß** die Feldplattenabschirmung durch eine Abschirmschicht (8) über der Oberfläche der Emitterzone (2) und der Basiszone (1) der Kathodenanordnung (10) ausgebildet ist.

5. GTO-Thyristor nach einem der vorhergehenden Ansprüche,
**dadurch gekennzeichnet,**
**daß** die Abschirmschicht (8) zumindest die Oberfläche des Halbleiterkörpers über der Basiszone (1) und der Emitterzone (2) der Kathodenanordnung überdeckt.

6. GTO-Thyristor nach einem der vorhergehenden Ansprüche,
**dadurch gekennzeichnet,**
**daß** die Feldplattenabschirmung durch eine Abschirmschicht (8) über der Basiszone (1) der Gateanordnung ausgebildet ist.

7. GTO-Thyristor nach einem der vorhergehenden Ansprüche,
**dadurch gekennzeichnet,**
**daß** die Feldplattenabschirmung aus mindestens zwei seitlich versetzt angeordneten Abschirmschichten besteht, die zur Bildung des Austrittsbereiches (20) für die Feldstärke-Äquipotentiallinien zumindest im Randbereich einer der Abschirmschichten (8) in der Höhe beabstandete voneinander angeordnet sind.

8. GTO-Thyristor nach Anspruch 6,
**dadurch gekennzeichnet,**
**daß** die voneinander beabstandeten Randbereiche der Abschirmschichten überlappend angeordnet sind.

9. GTO-Thyristor nach einem der vorhergehenden Ansprüche,
**dadurch gekennzeichnet,**
**daß** die Abschirmschicht (8) die Oberfläche der Emitterzone (2) der Kathodenanordnung (10) und in deren Mitte kontaktiert und von dieser Mitte auf einer Isolatorschicht (15) in einem Bereich oberhalb des an die Oberfläche des Halbleiterkörpers tretenden pn-Überganges zwischen Basiszone (1) und Emitterzone (2) verläuft und dort von einer Emitterelektrode (13) kontaktiert ist.

10. GTO-Thyristor nach einem der vorhergehenden Ansprüche,
**dadurch gekennzeichnet,**
**daß** die Abschirmschicht (8) aus dotiertem polykristallinem Silicium besteht.

## Claims

1. GTO thyristor comprising a cathode and gate arrangement and a field plate screening (8) at the semiconductor surface,
**characterized**
**in that** the field plate screening at the semiconductor surface is formed as an uninterrupted covering of at least that region of the base zone (1) of the cathode arrangement (10) in which the space charge zone forms, in that the extent of the space charge zone is delimited by a stopper zone (16) of the type of the base zone (1), which has an increased doping with respect to the base zone (1) and extends at least as far as below an edge of the field plate screening.

2. GTO thyristor according to Claim 1,
**characterized**
**in that** there is present alongside the field plate screening a laterally leading passage region (20) - free of the field plate screening - for the field strength equipotential lines.

3. GTO thyristor according to Claim 1 or 2,
**characterized**
**in that**, in the case of a mesa structure of the base zone (1) of the cathode arrangement, an insulator layer (15) is present between the sidewall (21) of the mesa structure (1) and an adjacent insulation layer (7) running at the semiconductor surface, with the formation of an insulator gap (22), and in that the insulator gap (22) forms the exit region (20) for the field strength equipotential lines.

4. GTO thyristor according to one of the preceding claims,
**characterized**
**in that** the field plate screening is formed by a screening layer (8) over the surface of the emitter zone (2) and the base zone (1) of the cathode arrangement (10).

5. GTO thyristor according to one of the preceding claims,
**characterized**
**in that** the screening layer (8) covers at least the surface of the semiconductor body over the base zone (1) and the emitter zone (2) of the cathode arrangement.

6. GTO thyristor according to one of the preceding claims,
**characterized**
**in that** the field plate screening is formed by a screening layer (8) over the base zone (1) of the gate arrangement.

7. GTO thyristor according to one of the preceding claims,
**characterized**
**in that** the field plate screening comprises at least two screening layers which are arranged in laterally offset fashion and are arranged in a manner spaced apart from one another in terms of height at least in the edge region of one of the screening layers (8) in order to form the exit region (20) for the field strength equipotential lines.

8. GTO thyristor according to Claim 6,
**characterized**
**in that** the edge regions of the screening layers which are spaced apart from one another are arranged in overlapping fashion.

9. GTO thyristor according to one of the preceding claims,
**characterized**
**in that** the screening layer (8) makes contact with the surface of the emitter zone (2) of the cathode arrangement (10) and in the centre thereof and runs from said centre on an insulator layer (15) in a region above the pn junction - which passes to the surface of the semiconductor body - between base zone (1) and emitter zone (2), where an emitter electrode (13) makes contact with said screening layer.

10. GTO thyristor according to one of the preceding claims,
**characterized**
**in that** the screening layer (8) is composed of doped polycrystalline silicon.

## Revendications

1. Thyristor de type GTO ayant un dispositif de cathode et de gâchette et une protection (8) de plaque de champ sur la surface semi-conductrice,
**caractérisé**
**en ce que** la protection de plaque de champ sur la surface semi-conductrice est sous la forme d'un recouvrement sans lacune d'au moins la partie de la zone (1) de base du dispositif (10) de cathode dans lequel se forme la zone de charge d'espace, en ce que l'étendue de la zone de charge d'espace est limitée par une zone (16) d'arrêt du type de la zone (1) de base qui a un dopage plus grand que celui de la zone (1) de base et qui va jusqu'au moins sous un bord de la protection de plaque de champ.

2. Thyristor de type GTO suivant la revendication 1,
**caractérisé**
**en ce qu'**il y a, à côté de la protection de plaque de champ, une partie (20) de passage, débouchant latéralement et sans protection de plaque de champ, pour les lignes équipotentielles d'intensité du champ.

3. Thyristor de type GTO suivant la revendication 1 ou 2,
**caractérisé**
**en ce que**, lorsque la zone (1) de base du dispositif de cathode a une structure mésa, il y a, entre le flanc (21) de la structure (1) mésa et une couche (7) isolante voisine s'étendant sur la surface semi-conductrice avec formation d'un intervalle (22) d'isolateur, une couche (15) d'isolateur, et en ce que l'intervalle (22) d'isolateur forme la partie (20) de sortie de lignes équipotentielles de l'intensité du champ.

4. Thyristor de type GTO suivant l'une des revendications précédentes,
**caractérisé**
**en ce que** la protection de plaque de champ est formée par une couche (8) de protection sur la surface de la zone (2) d'émetteur et de la zone (1) de base du dispositif (10) de cathode.

5. Thyristor de type GTO suivant l'une des revendications précédentes,
**caractérisé**
**en ce que** la couche (8) de protection recouvre au moins la surface du corps semi-conducteur au-dessus de la zone (1) de base et de la zone (2) d'émetteur du dispositif de cathode.

6. Thyristor de type GTO suivant l'une des revendications précédentes,
**caractérisé**
**en ce que** la protection de plaque de champ est formée par une couche (8) de protection au-dessus de la zone (1) de base du dispositif de gâchette.

7. Thyristor de type GTO suivant l'une des revendications précédentes,
**caractérisé**
**en ce que** la protection de plaque de champ est constituée d'au moins deux couches de protection décalées latéralement qui, pour former la partie (20) de sortie des lignes équipotentielles d'intensité du champ, sont disposées en hauteur à distance l'une de l'autre au moins dans la partie de bord de l'une des couches (8) de protection.

8. Thyristor de type GTO suivant la revendication 6,
**caractérisé**
**en ce que** les parties de bord à distance l'une de l'autre des couches de protection se chevauchent.

9. Thyristor de type GTO suivant l'une des revendications précédentes,
**caractérisé**
**en ce que** la couche (8) de protection est en contact avec la surface de la zone (2) d'émetteur du dispositif (10) de cathode et en son milieu et s'étend à partir de ce milieu sur une couche (15) d'isolateur dans une partie au-dessus de la jonction pn se produisant à la surface du corps semi-conducteur entre la zone (1) de base et la zone (2) d'émetteur, et de là est en contact avec une électrode (13) d'émetteur.

10. Thyristor de type GTO suivant l'une des revendications précédentes,
**caractérisé**
**en ce que** la couche (8) de protection est en silicium polycristallin dopé.
